# EUROPEAN PATENT APPLICATION

(11) **EP 2 434 535 A2**
(43) Date of publication of application: **28.03.2012**
(21) Application number: 11182469.4
(22) Date of filing: 23.09.2011
(51) Int. Cl.: H01L 21/28, H01L 21/336, H01L 29/792, H01L 27/115, G11C 16/04, H01L 29/423

(54) **Non-volatile memory transistor with a self-aligned nitride storage layer**

(30) Priority: 26.09.2010 US 386558 P
(71) Applicant: EMemory Technology Inc., Hsin-Chu 30075 (CN)
(72) Inventor: Lu, Hau-Yan, 300 Hsinchu City (TW); Chen, Hsin-Ming, 300 Hsinchu City (TW); Yang, Ching-Sung, 300 Hsinchu City (TW)
(74) Representative: Becker Kurig Straus

(57) **Abstract**

A method of forming a self-aligning nitride charge-storing layer (314, 2014-1, 2014-2, 2014-3, 2014-4) in a non-volatile memory cell (300, 700, 1100, 1300, 1500, 1600, 2000) in a logic process includes forming a select gate (313-1, 2013-1, 2013-2) over an active region (315, 715, 815, 2150-1, 2150-2) of a substrate, forming long polysilicon gates (313-2, 313-3, 713-2, 713-3, 813-1, 813-N, 1118-1, 1118-2) partially overlapping the active region (315, 715, 815, 2150-1, 2150-2) of the substrate, and filling the charge-storing layer (314, 2014-1, 2014-2, 2014-3, 2014-4) between the long polysilicon gates (313-2, 313-3, 713-2, 713-3, 813-1, 813-N, 1118-1, 1118-2).

## Description

### Field of the Invention

The present invention relates to non-volatile memory, and more particularly to a semiconductor non-volatile memory with self-aligning nitride (SAN) storage node and related fabrication method according to the pre-characterizing clause of claims 1 and 5.

### Background of the Invention

Non-volatile memory is a type of memory that retains information it stores even when no power is supplied to memory blocks thereof. Some examples include magnetic devices, optical discs, flash memory, and other semiconductor-based memory topologies. Some forms of non-volatile memory have bits defined in fabrication, some may be programmed only once (one time programmable ROM, OTP ROM), and other types may be programmed and reprogrammed many times over. As semiconductor memory technologies have matured, one advantage that has come out of development of such technologies is the ability to integrate substantial amounts of memory cells in integrated circuits (ICs). However, it is desirable that the memory cells be formed in the same process with the ICs.

Many various topologies are provided in the prior art for forming memory cells with charge storage layers. However, the memory cells are slow and inefficient.

### Summary of the Invention

This in mind, the present invention aims at providing a device and method of forming a charge-storing layer in a non-volatile memory cell in a logic process that improves efficiency and performance.

This is achieved by a device and method of forming a charge-storing layer in a non-volatile memory cell in a logic process according to claims 1 and 5. The dependent claims pertain to corresponding further developments and improvements.

As will be seen more clearly from the detailed description following below, the claimed device and method of forming a charge-storing layer in a non-volatile memory cell in a logic process includes a photoresist that shortens length of the charge-storing layers and prevents the gap that forms due to polysilicon pull-back and rounding.

According to some embodiments, a method of forming a charge-storing layer in a non-volatile memory cell in a logic process includes forming a select gate over an active region of a substrate, forming long polysilicon gates partially overlapping the active region of the substrate, and filling the charge-storing layer between the long polysilicon gates.

According to some embodiments, a non-volatile semiconductor memory device formed in a logic process comprises a substrate, a first gate, a second gate, a charge storage layer, a first diffusion region, and a second diffusion region. The substrate is of a first conductivity type, and comprises an active region. The first gate is formed partially in the active region on a first region of a surface of the substrate, and is longer than a minimum gate length rule of the logic process. The second gate is formed partially in the active region on a second region of the surface of the substrate. The first region and the second region are separated by a first distance, and the second gate is substantially the same length as the first gate. The charge storage layer is formed on the substrate, and is filled between the first gate and the second gate. The first diffusion region is of a second conductivity type opposite the first conductivity type, and is formed on a first side of the charge storage layer in the active region. The second diffusion region is of the second conductivity type, and is formed on a second side of the charge storage layer opposite the charge storage layer from the first side in the active region.

According to some embodiments, a non-volatile memory array comprises a substrate of a first conductivity type, a plurality of active regions on the substrate, and a plurality of memory cells. Each memory cell is formed on one active region of the plurality of active regions, and comprises a select gate formed fully on the one active region, a first gate, a second gate, a charge storage layer, a first diffusion region, a second diffusion region, and a third diffusion region. The first gate is formed partially on the active region on a first side of the select gate, wherein the select gate and the first gate are separated by a first distance, and the first gate is longer than a minimum gate length rule of the logic process. The second gate is formed partially on the one active region on the first side of the select gate, wherein the second gate and the select gate are separated by the first distance, the first gate and the second gate are separated by a second distance, and the second gate is substantially the same length as the first gate. The charge storage layer is formed between the first gate and the second gate. The first diffusion region is of a second conductivity type opposite the first conductivity type, and is formed on the surface of the active region, wherein the first diffusion region and the second gate are formed on opposite sides of the select gate. The second diffusion region is of the second conductivity type, and is formed on the surface of the active region, wherein the second diffusion region and the select gate are formed on opposite sides of the first gate. First diffusion regions of the plurality of memory cells are electrically connected to each other, and second diffusion regions of the plurality of memory cells are electrically connected to each other.

### Brief Description of the Drawings

In the following, the invention is further illustrated by way of example, taking reference to the accompanying drawings. Thereof
FIG 1 is a diagram of a semiconductor memory transistor,
FIG 2 is a diagram of a CMOS non-volatile memory cell,
FIG 3 is a diagram of a complimentary metal-oxide-semiconductor non-volatile memory cell according to one embodiment of the present invention,
FIG 4 is a cross-sectional diagram of the CMOS non-volatile memory cell along line 4-4' of FIG 3 in program mode,
FIG 5 is a diagram of the CMOS non-volatile memory cell of FIG 4 in erase mode,
FIG 6 is a diagram of a complimentary metal-oxide-semiconductor non-volatile memory cell showing sidewall spacers,
FIG 7 is a diagram of a complimentary metal-oxide-semiconductor non-volatile memory cell according to another embodiment of the present invention,
FIG 8 is a diagram of an array of complimentary metal-oxide-semiconductor non-volatile memory cells according to an embodiment of the present invention,
FIG 9 is a diagram illustrating failed formation of a charge-storing structure in a non-volatile memory cell,
FIG 10 is a diagram illustrating typical conditions exhibited after fabrication of the non-volatile memory cell of FIG 1,
FIG 11 is a diagram of a non-volatile memory cell according to an embodiment,
FIG 12 is a cross-sectional diagram of the non-volatile memory cell along the line 12-12' of FIG 11,
FIG 13 is a diagram of a non-volatile memory cell according to an embodiment,
FIG 14 is a cross-sectional diagram of the non-volatile memory cell along the line 14-14' of FIG 13,
FIG 15 is a diagram of a non-volatile memory cell according to an embodiment,
FIG 16 is a diagram of another non-volatile memory cell according to an embodiment,
FIG 17 is a cross-sectional diagram of the non-volatile memory cell along the line 17-17' of FIG 7 or FIG 8 after deposition of self-aligning nitride,
FIG 18 is a diagram illustrating application of photoresist covering the charge-storing structure of FIG 15 or FIG 16,
FIG 19 is a diagram illustrating the charge-storing structure of FIG 15 or FIG 16 after etching, and
FIG 20 is a diagram of a non-volatile memory array.

### Detailed Description

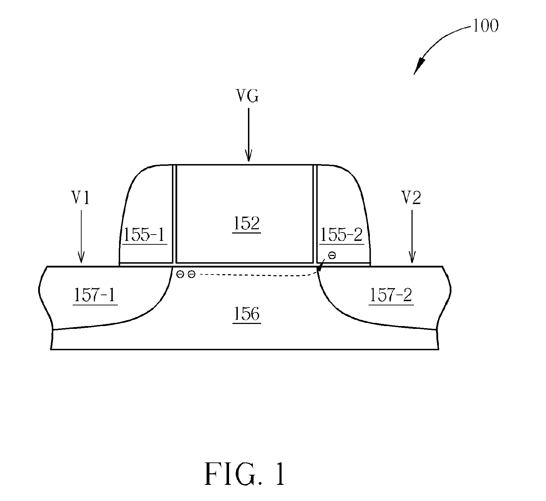

One goal of non-volatile memory devices is to fit increasing numbers of memory cells in smaller chip areas while utilizing the same fabrication process as other complementary metal-oxide-semiconductor (CMOS) devices in the IC. One method for increasing the number of memory cells utilizes "charge storage structures" to form 2-bit non-volatile semiconductor memory transistors. Please refer to FIG 1, which is a diagram of a semiconductor memory transistor 100 according to the prior art. The semiconductor memory transistor 100 is formed on a substrate, which has two implanted source/drain regions 157-1 and 157-2 and a channel region 156. The channel region 156 and the implanted source/drain regions 157-1, 157-2 are formed under a gate region 152, and two charge storage structures 155-1 and 155-2 formed on either side of the gate region 152. The charge storage structures 155-1, 155-2 are made of a spacer material that has charge trapping properties, e.g. silicon-nitride or a high-k dielectric. The charge storage structure 155-2 is programmed by applying a gate voltage VG of 5 Volts and a drain voltage V2 of 5 Volts, with a source voltage V1 of 0 Volts. Thus, channel hot electrons from the source region 157-1 may enter the charge storage region 155-2 by traveling through the channel region 156. To erase the charge storage structure 155-2, a gate voltage VG of -5 Volts and a drain voltage V2 of -5 Volts may be applied, inducing band-to-band tunneling holes to enter the charge storage structure 155-2.

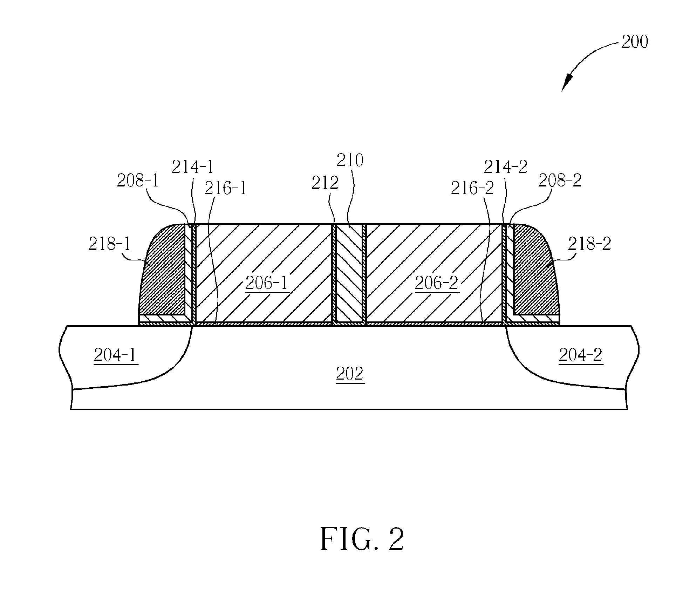

Another technique for providing a CMOS non-volatile memory cell that is fabricated using standard CMOS processes is shown in FIG 2, which is a diagram of a CMOS non-volatile memory cell 200 ("memory cell 200" hereinafter) according to the prior art. The memory cell 200 is fabricated on a substrate 202, has two source/drain regions 204-1 and 204-2, and two poly gates 206-1 and 206-2 separated from the substrate 202 by gate dielectric layers 208-1 and 208-2, respectively. The gate dielectric layers 208-1/208-2 are formed of oxide-nitride-oxide (ONO) material. A programming layer 210 is formed between the two poly gates 206-1, 206-2, and is isolated from the two poly gates 206-1, 206-2 by an isolating layer 212. The programming layer 210 provides charge storage similar to a silicon-oxide-nitride-oxide-silicon (SONOS) structure utilized in flash memory cells. However, in the CMOS non-volatile memory cell 200, the two poly gates 206-1, 206-2 are utilized to program the programming layer 210. Silicon-nitride sidewall spacers 214-1 and 214-2 are deposited with the programming layer 210 for controlling e-field fringing near the source/drain regions 204-1, 204-2. Sidewall isolating layers 216-1 and 216-2 are grown with the isolating layer 212, and isolate the SiN sidewall spacers 214-1, 214-2 from the poly gates 206-1, 206-2 and the substrate 202. Second sidewall spacers 218-1, 218-2 are formed from silicon oxide. The programming layer 210 is programmed by grounding the poly gate 206-1, and leaving the source/drain regions 204-1, 204-2 and substrate 202 floating. A high voltage is applied to the poly gate 206-2 to attract electrons from the poly gate 206-1 into the programming layer 210 through the isolating layer 212. The negative charge of the programming layer 210 over the channel causes a negative bias, increasing threshold voltage of the memory cell 200 relative to non-programmed transistors in the same circuit.

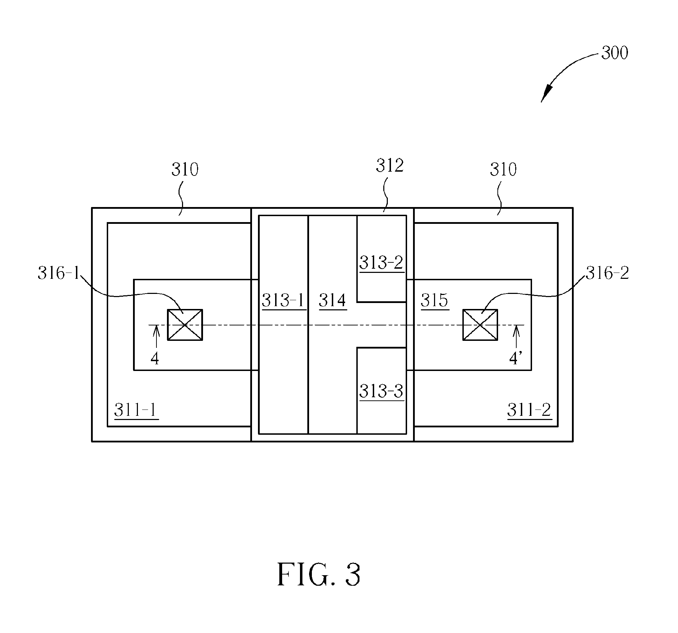

Please refer to FIG. 3, which is a diagram of a complimentary metal-oxide-semiconductor (CMOS) non-volatile memory cell 300 (hereinafter "the memory cell 300") according to one embodiment of the present invention. The memory cell 300 may be formed over an active region 315 in a P-well region 310 of a substrate. Although P-well topology CMOS is described, the embodiments described herein are also suitable for application to N-well topology CMOS. A first N+ diffusion region 311-1 may be formed under a first polysilicon gate 313-1, and a second N+ diffusion region may be formed under a second polysilicon gate 313-2 and a third polysilicon gate 313-3.

The second polysilicon gate 313-2 and the third polysilicon gate 313-3 may be formed a first distance apart from each other. Further, the second polysilicon gate 313-2 and the third polysilicon gate 313-3 may both be formed a second distance apart from the first polysilicon gate 313-1. The first distance and the second distance may be of sizes suitable for forming self-aligning nitride (SAN) layers in a space between the first, second, and third polysilicon gates 313-1, 313-2, 313-3. For example, in a 90nm/65nm node, a range of 20nm to 200nm of separation between the first polysilicon gate 313-1 and the second and third polysilicon gates 313-2, 313-3, as well as between the second polysilicon gate 313-2 and the third polysilicon gate 313-3, may allow formation of a charge storage layer 314, e.g. a SAN layer, in the space between the first, second, and third polysilicon gates 313-1, 313-2, 313-3. Contacts 316-1 and 316-2 may be formed in the active region 315 over the diffusion regions 311-1 and 311-2, respectively, for charging the diffusion regions 311-1, 311-2 with voltage signals applied to the contacts 316-1, 316-2. A lightly-doped drain (LDD) block region may also be formed in and surrounding a region of the substrate over which the first, second, and third polysilicon gates 313-1, 313-2, 313-3 and the SAN layer 314 are formed.

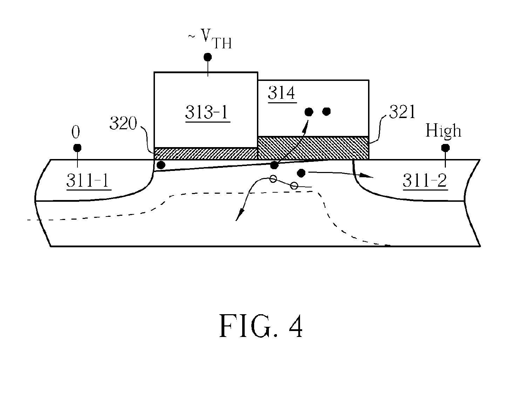

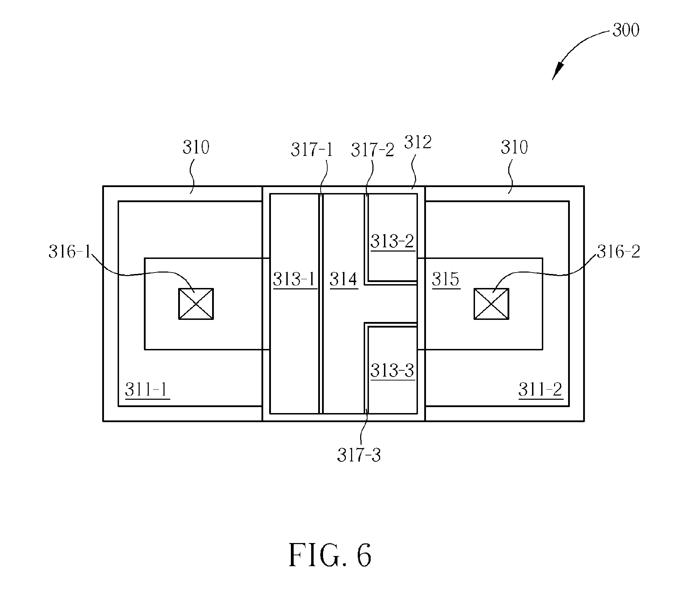

Please refer to FIG 4, which is a cross-sectional diagram of the CMOS non-volatile memory cell 300 along line 4-4' of FIG. 3. FIG 4 shows the memory cell 300 in program mode. A first oxide layer 320 may be formed between the first polysilicon gate 313-1. In program mode, for an N-type MOSFET, a gate voltage of approximately a threshold voltage V_{TH} of the memory cell 300 may be applied to the polysilicon gate 313-1, a high voltage may be applied to the diffusion region 311-2 ("second diffusion region"), and the diffusion region 311-1 ("first diffusion region") may be grounded. In this way, channel hot electrons may travel from the first diffusion region 311-1 through a channel region formed between the toward the second diffusion region 311-2. Likewise, holes may travel from the second diffusion region 311-2 toward the P-well 310. The channel hot electrons may be injected into the SAN layer 314 through a second oxide layer 321 formed between the SAN layer 314 and the substrate. Addition of the second and third polysilicon gates 313-2, 313-3 may couple high voltage to sidewall spacers 317-1, 317-2, 317-3 (see FIG 6) adjacent the SAN layer 314, which may greatly enhance channel hot electron injection efficiency. The sidewall spacers 317-1, 317-2, 317-3 may be formed of oxide grown on the substrate and the second and third polysilicon gates 313-2, 313-3. Further, peak channel hot electron injection may be shifted to an edge of the second diffusion region 311-2 under the SAN layer 314, and current density may be enhanced by applying voltage to the second and third polysilicon gates 313-2, 313-3.

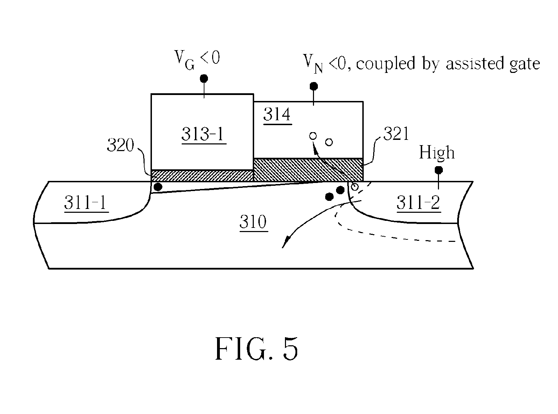

Please refer to FIG 5, which is a diagram of the CMOS non-volatile memory cell 300 of FIG 4 in erase mode. Band-to-band tunneling hot hole (BBHH) injection may be utilized to erase the memory cell 300. As shown in FIG 5, a low voltage, e.g. <0 Volts, may be applied to the first polysilicon gate 313-1, and a SAN layer voltage VN, e.g. <0 Volts, may be coupled to the sidewall spacers 317-1, 317-2, 317-3 next to the SAN layer 314 by the second and third polysilicon gates 313-2, 313-3. A high voltage may be applied to the second diffusion region 311-2. In this way, BBHH injection may occur, such that hot holes may travel from the second diffusion region 311-2 to the SAN layer 314 through the oxide layer 321. Likewise, electrons may travel toward the P-well 310 due to the low voltage coupled through the sidewall spacers 317-1, 317-2, 317-3 by the second and third polysilicon gates 313-2, 313-3. Thus, hot hole injection current may be enhanced due to an external vertical electric field in the sidewall spacers 317-1, 317-2, 317-3 induced through the second and third polysilicon gates 313-2, 313-3.

Thus, it can be seen that through addition of the second and third polysilicon gates 313-2, 313-3, the memory cell 300 has enhanced current density in both program and erase modes, which improves performance of the memory cell 300 over the prior art. Further, in simulation, the memory cell 300 exhibits an acceptable program/erase window under 2 Volts operation.

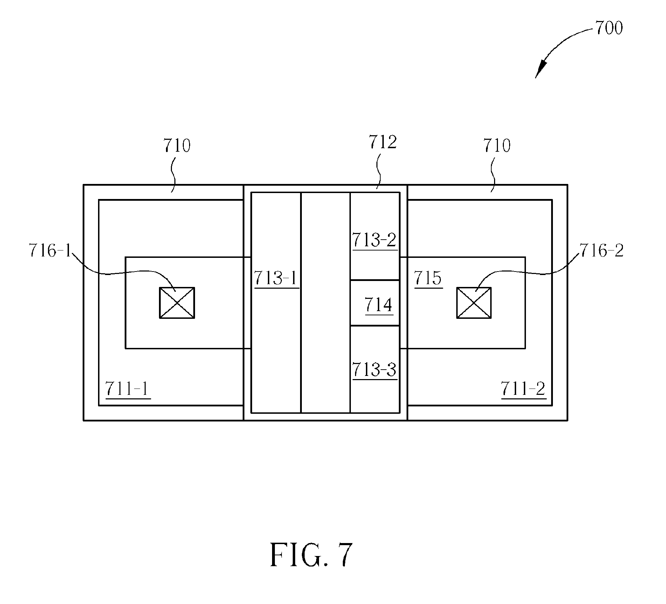

Please refer to FIG 7, which is a diagram of a complimentary metal-oxide-semiconductor non-volatile memory cell 700 (hereinafter "the memory cell 700") according to another embodiment of the present invention. The memory cell 700 may be formed over an active region 715 in a P-well region 710 of a substrate. A first N+ diffusion region 711-1 may be formed under a first polysilicon gate 713-1, and a second N+ diffusion region may be formed under a second polysilicon gate 713-2 and a third polysilicon gate 713-3.

The second polysilicon gate 713-2 and the third polysilicon gate 713-3 may be formed a first distance apart from each other. Further, the second polysilicon gate 713-2 and the third polysilicon gate 713-3 may both be formed a second distance apart from the first polysilicon gate 713-1. The second distance and the first distance may be measured along perpendicular axes. The first polysilicon gate 713-1 may be wider than the second and third polysilicon gates 713-2, 713-3. The first distance may be of a size suitable for forming a self-aligning nitride (SAN) layer 714 in a space between the second and third polysilicon gates 713-2, 713-3, and the second distance may be of a size suitable for not forming an SAN layer between the first polysilicon gate 713-1 and the second and third polysilicon gates 713-2, 713-3. For example, in a 90nm/65nm node, a range of 20nm to 200nm of separation between the second and third polysilicon gates 713-2, 713-3 may allow formation of a charge storage layer 714, e.g. the SAN layer, in the space between the second and third polysilicon gates 713-2, 713-3. Contacts 716-1 and 716-2 may be formed in the active region 715 over the diffusion regions 711-1 and 711-2, respectively, for charging the diffusion regions 711-1, 711-2 with voltage signals applied to the contacts 716-1, 716-2.

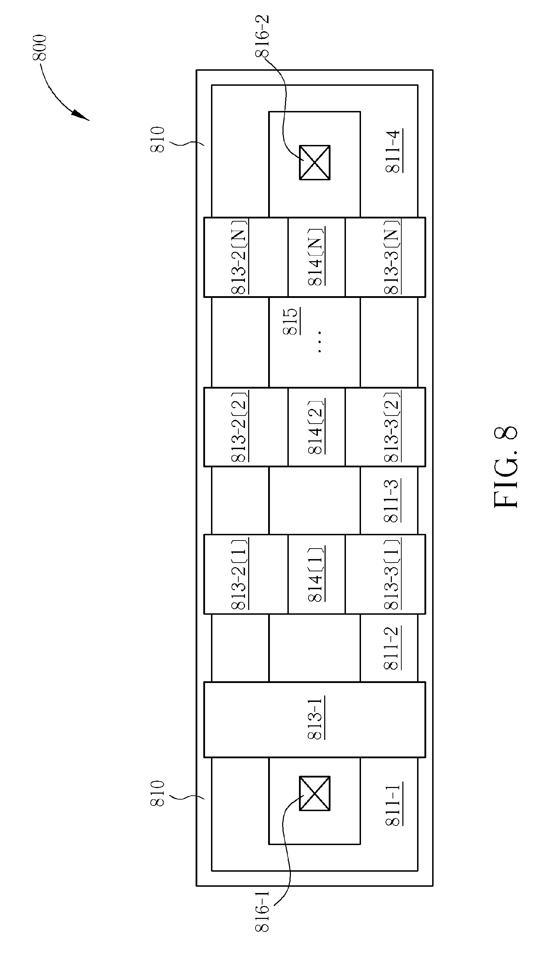

Please refer to FIG 8, which is a diagram of an array 800 of complimentary metal-oxide-semiconductor non-volatile memory cells according to an embodiment of the present invention. The array of memory cells 800 may be considered a logical NAND type array comprising a plurality of memory cells in a memory string. Each memory string may comprise a plurality of memory cells as shown in FIG 8. The memory cells 800 may be formed over an active region 815 in a P-well region 810 of a substrate. As shown in FIG 8, a total number N memory cells may be formed. A first N+ diffusion region 811-1 may be formed under a first polysilicon gate 813-1. A second N+ diffusion region 811-2 may be formed under the first polysilicon gate 813-1 and second and third polysilicon gates 813-2[1], 813-3[1]. A third N+ diffusion region 811-3 may be formed under the second and third polysilicon gates 813-2[1], 813-3[1] and under fourth and fifth polysilicon gates 813-2[2], 813-3 [2]. A fourth N+ diffusion region 811-4 may be formed under sixth and seventh polysilicon gates 813-2[N], 813-3[N]. To form a continuous channel between the first N+ diffusion region 811-1 and the fourth N+ diffusion region 811-4, each charge storage layer 814[1], 814[2],...,814[N] may store charges, e.g. electrons. If one or more of the charge storage layers 814[1], 814[2],...,814[N] does not store charges, current may not pass from the first N+ diffusion region 811-1 to the fourth N+ diffusion region 811-4. Thus, NAND-type operation may be achieved through use of the architecture shown in FIG 8.

The second polysilicon gate 813-2[1] and the third polysilicon gate 813-3[1] may be formed a first distance apart from each other. Further, the second polysilicon gate 813-2[1] and the third polysilicon gate 813-3[1] may both be formed a second distance apart from the first polysilicon gate 813-1. The fourth polysilicon gate 813-2[2] and the fifth polysilicon gate 813-3[2] may be formed the first distance apart from each other. The fourth polysilicon gate 813-2[2] may be formed a third distance apart from the second polysilicon gate 813-2[1]. The fifth polysilicon gate 813-3[2] may be formed the third distance apart from the third polysilicon gate 813-3[1]. The third distance may be the same as the second distance. The first distance may be of a size suitable for forming the self-aligning nitride (SAN) layers 814[1], 814[2],...,814[N] in spaces between the second and third polysilicon gates 813-2[1], 813-3[1], fourth and fifth polysilicon gates 813-2[2], 813-3[2], through the sixth and seventh polysilicon gates 813-2[N], 813-3[N]. The second distance may be of a size suitable for not forming an SAN layer between the first polysilicon gate 813-1 and the second and third polysilicon gates 813-2[1], 813-3[1]. The third distance may be of a size suitable for not forming an SAN layer between the second and third polysilicon gates 813-1[1], 813-3[1] and the fourth and fifth polysilicon gates 813-2[2], 813-3[2], respectively. For example, in a 90nm/65nm node, a range of 20nm to 200nm of separation between the second and third polysilicon gates 813-2[1], 813-3[1] may allow formation of a charge storage layer 814[1], e.g. the SAN layer, in the space between the second and third polysilicon gates 813-2[1], 813-3[1]. Contacts 816-1 and 816-2 may be formed in the active region 815 over the diffusion regions 811-1 and 811-4, respectively, for charging the diffusion regions 811-1, 811-4 with voltage signals applied to the contacts 816-1, 816-2.

The above description of FIG 8 relates to a NAND-type array configuration. A NOR-type array configuration is also described herein as follows. ANOR-type array may comprise a plurality of memory cells, each configured as the memory cell 300 or the memory cell 700. Taking the memory cell 700 as an example, each first diffusion region 711-1 may be electrically connected to other first diffusion regions 711-1 of other memory cells of the NOR-type array, and each second diffusion region 711-2 may be electrically connected to other second diffusion regions 711-2 of the other memory cells of the NOR-type array. In such a configuration, if one or more charge storage layers 714 corresponding to one or more memory cells of the NOR-type array is charged, forming one or more channels from the first diffusion region 711-1 to the second diffusion region 711-2 of the one or more memory cells, current may travel through the channel from the first diffusion region 711-1 to the second diffusion region 711-2. Thus, logical NOR-type operation may be accomplished in the NOR-type array.

Thus, it can be seen that the memory cell 700 has enhanced current density through the SAN layer 714, which improves performance of the memory cell 700 over the prior art. Likewise, the array of memory cells 800 and the NOR-type array benefit from the SAN layers described above in a similar manner.

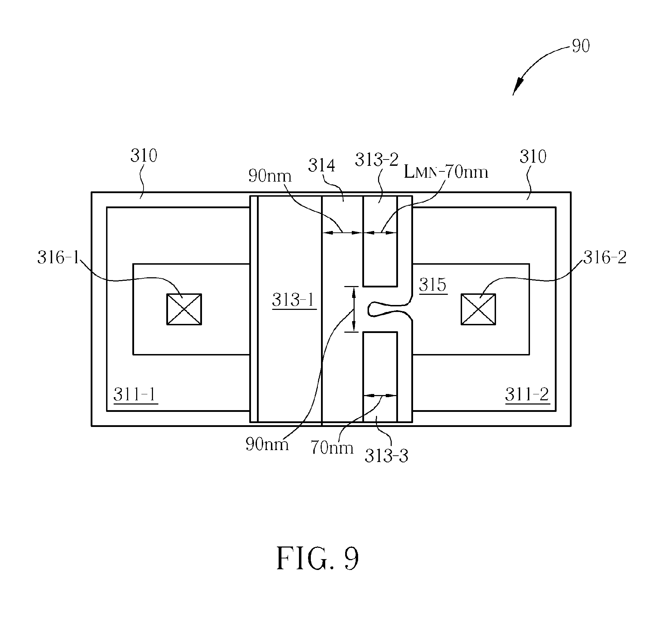

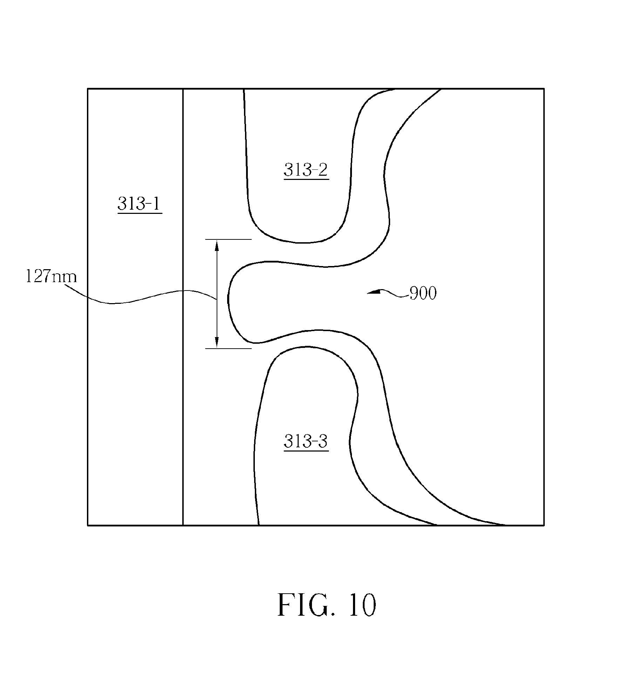

The self-aligning nitride (SAN) layer can be used as a charge-storing structure in non-volatile memory cells, and allows for increased memory bit density per unit area in layout of an array of the non-volatile memory cells. The SAN layer also enhances current density (program and read currents) of each non-volatile memory cell. However, polysilicon tends to pull back during fabrication, and also exhibits rounded edges, which together increase a gap size between gates used to form the self-aligning charge-storing structure. Please refer to FIG 9 and FIG 10. FIG 9 is a diagram illustrating failed formation of the charge-storing structure 314 in the non-volatile memory cell 300. FIG 10 is a diagram illustrating typical conditions exhibited after fabrication of the non-volatile memory cell 300. As shown in FIG 9, a minimum channel length L_{MIN} (e.g. 70 nm) is used for polysilicon gates 313-2, 313-3, and minimum separation is left between the polysilicon gates 313-2, 313-3 (e.g. 90 nm) to promote formation of the SAN charge-storing structure 314. However, while the charge-storing structure 314 forms between the select gate 313-1 and the polysilicon gates 313-2, 313-3, the charge-storing structure 314 is not properly formed between the polysilicon gates 313-2, 313-3, leaving a gap 900 between the polysilicon gates 313-2, 313-3 after etch. As shown in FIG 10, instead of the ideal 90 nm separation expected between the polysilicon gates 313-2, 313-3, a much larger separation of approximately 127 nm is formed due to the pull back and rounding phenomena mentioned above. Thus, the SAN charge-storing structure 314 is not properly formed, and the gap 900 is formed instead between the polysilicon gates 313-2, 313-3. As a result, most current flows through the select gate 313-1 only, and control of the polysilicon gates 313-2, 313-3 is weak.

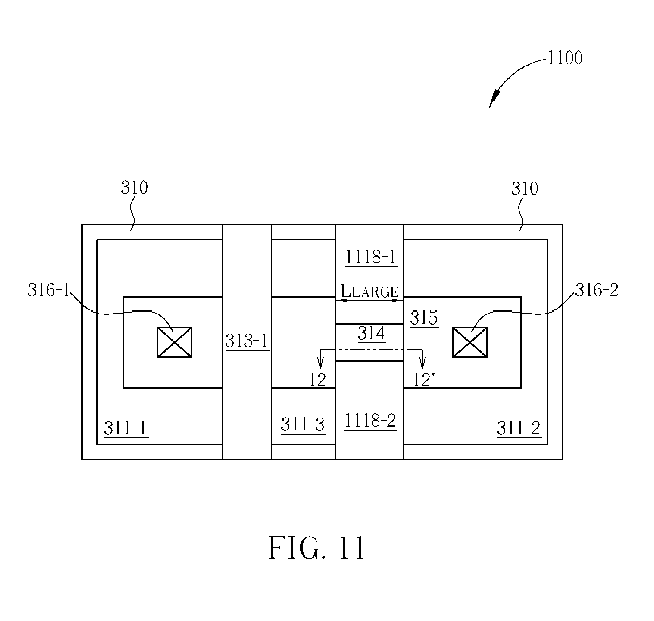

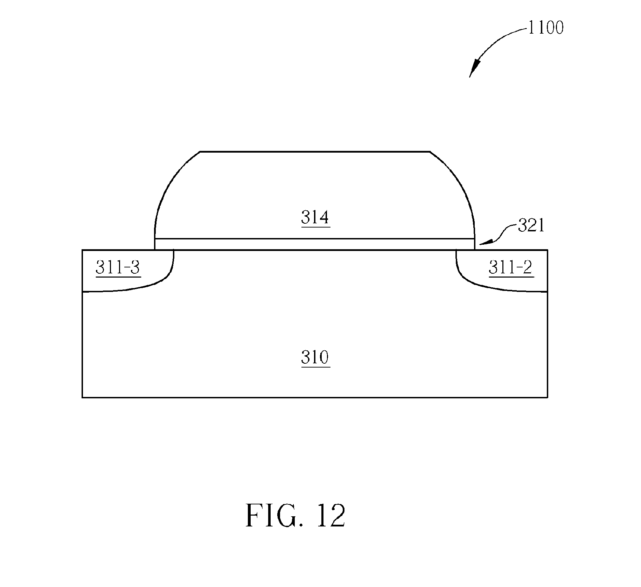

Please refer to FIG 11 and FIG 12. FIG 11 is a diagram of a non-volatile memory cell 1100. The non-volatile memory cell 1100 is similar to the non-volatile memory cells 300, 700, except that the non-volatile memory cell 1100 uses long polysilicon gates 1118-1, 1118-2 instead of the minimum length gates 313-2, 313-3 (or 713-2, 713-3). FIG 12 is a cross-sectional diagram of the non-volatile memory cell 30 along the line 12-12' of FIG 11. As shown in FIG 11, the select gate 313-1 and the long polysilicon gates 1118-1, 1118-2 are formed over the active region 315 within the lightly-doped drain (LDD) block 310. The long polysilicon gates 1118-1, 1118-2 both have length L_{LARGE} greater than the minimum channel length L_{MIN} defined by a foundry for a process in which the non-volatile memory cell 1100 is formed. Contacts 316-1, 316-2 are formed on opposite sides of the gates 313-1, 1118-1, 1118-2 as shown. The charge-storing structure 314 is formed between the long polysilicon gates 1118-1, 1118-2, and pull back does not affect the long polysilicon gates 1118-1, 1118-2, because the long polysilicon gates 1118-1, 1118-2 have the length L_{LARGE} longer than the minimum rule. As shown in FIG. 12, the oxide layer 321 is formed between the LDD block 310 and the charge-storing structure 314, and diffusion regions 311-2, 311-3 are formed on either side underlapping the charge-storing structure 314.

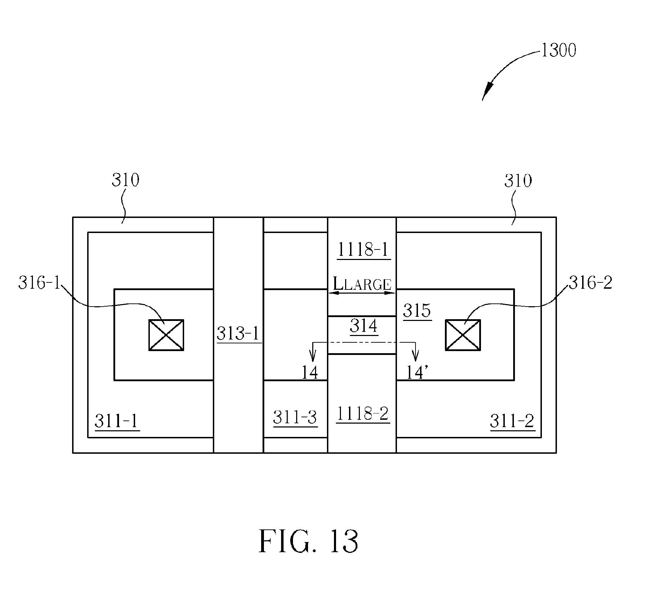

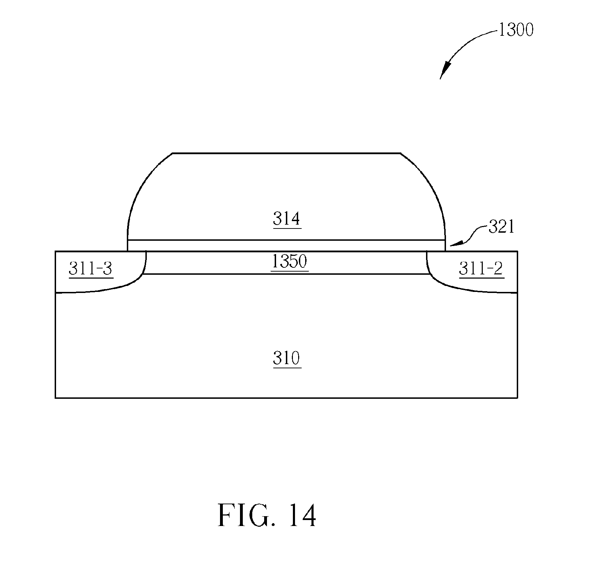

Please refer to FIG 13 and FIG 14. FIG 13 is a diagram of a non-volatile memory cell 1300. FIG 14 is a cross-sectional diagram of the non-volatile memory cell 1300 along the line 14-14' of FIG 13. Elements of FIG 11 and FIG 13 having the same reference numerals are structurally and functionally the same or similar. In the non-volatile memory cell 1100 shown in FIG 11, the long length L_{LARGE} of the long polysilicon gates 1118-1, 1118-2 causes reduced read current. In the non-volatile memory cell 1300 of FIG 13, an N-- implantation region 1350 is added to enhance channel conductivity underneath the charge-storing structure 314, which enhances on-state current (e.g. the read current).

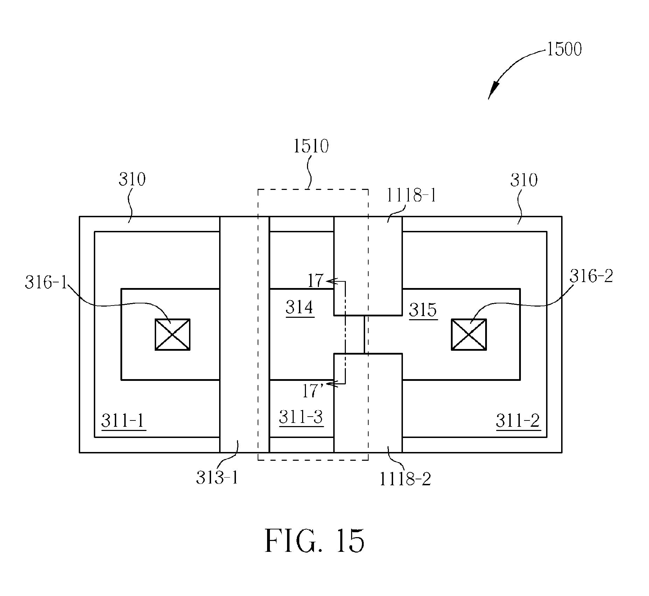

Please refer to FIG 15, which is a diagram of a non-volatile memory cell 1500. The non-volatile memory cell 1500 is similar to the non-volatile memory cell 300 in that the charge-storing structure 314 is filled between the select gate 313-1 and the long polysilicon gates 1118-1, 1118-2. The non-volatile memory cell 1500 is also similar to the non-volatile memory cell 1100 in the use of the long polysilicon gates 1118-1, 1118-2 instead of the minimum length gates 313-2, 313-3. In the non-volatile memory cell 1500, the charge-storing structure 314 is partially etched away in a controlled fashion through use of an additional photoresist layer 1510 partially covering the charge-storing layer 314 between the long polysilicon gates 1118-1, 1118-2 as depicted in FIG 15. After etching, the charge-storing layer 314 has length between the long polysilicon gates 1118-1, 1118-2 which is shorter than the long length L_{LARGE} thereof. This shortens the channel length in the non-volatile memory cell 1500, and allows for better programming efficiency.

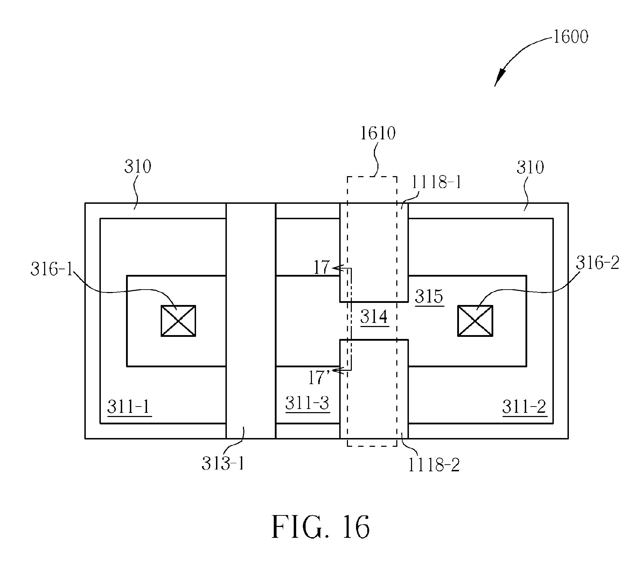

Please refer to FIG 16, which is a diagram of another non-volatile memory cell 1600. The non-volatile memory cell 1600 is similar to the non-volatile memory cell 1500 shown in FIG 15, and is configured for use in a memory cell array. In the non-volatile memory cell 1600, a photoresist layer 1610 is used, which is positioned along the long polysilicon gates 1118-1, 1118-2, and partially covers only the portion of the charge-storing layer 314 between the long polysilicon gates 1118-1, 1118-2. After etching, the charge-storing layer 314 has length shorter than the long length L_{LARGE} of the long polysilicon gates 1118-1, 1118-2. This shortens the channel length in the non-volatile memory cell 1600, and allows for better programming efficiency.

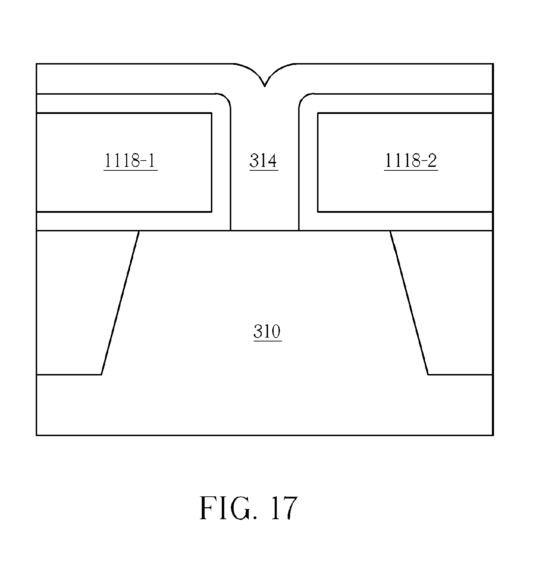

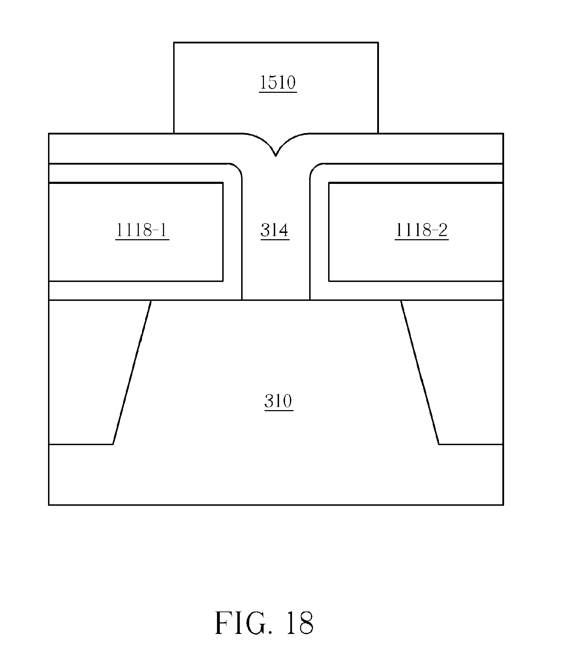

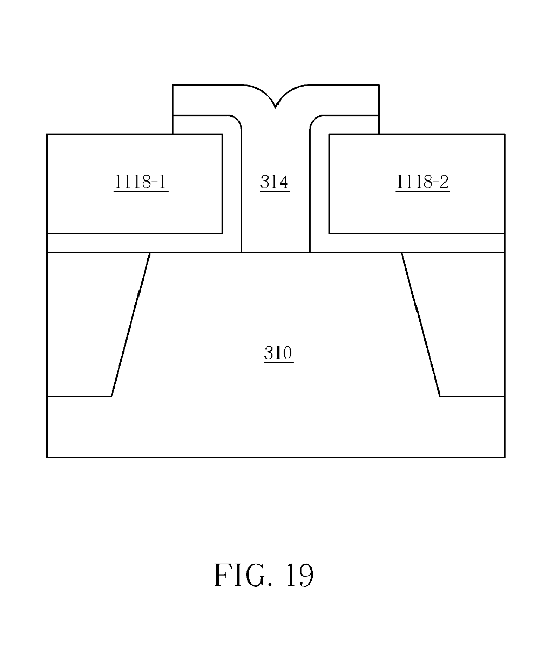

Please refer to FIG 17, FIG 18, and FIG 19, which are diagrams illustrating a process for fabricating the non-volatile memory cell 1500 of FIG 15. The process may also be used to fabricate the non-volatile memory cell 1600 of FIG 16. FIG 17 is representative of the cross-sections of either of the non-volatile memory cells 1500, 1600 shown in FIG 15 and FIG 16, respectively. As shown in FIG 17, due to the long length L_{LARGE} of the long polysilicon gates 1118-1, 1118-2, the charge-storing layer 314 is filled in between the long polysilicon gates 1118-1, 1118-2 with sufficient height. In FIG 18, the photoresist layer 1510 (or 1610) is formed over the charge-storing layer 314. In FIG 19, after etching, the charge-storing layer 314 still fills between the long polysilicon gates 1118-1, 1118-2, without exhibiting the gap 900 shown in FIG 9.

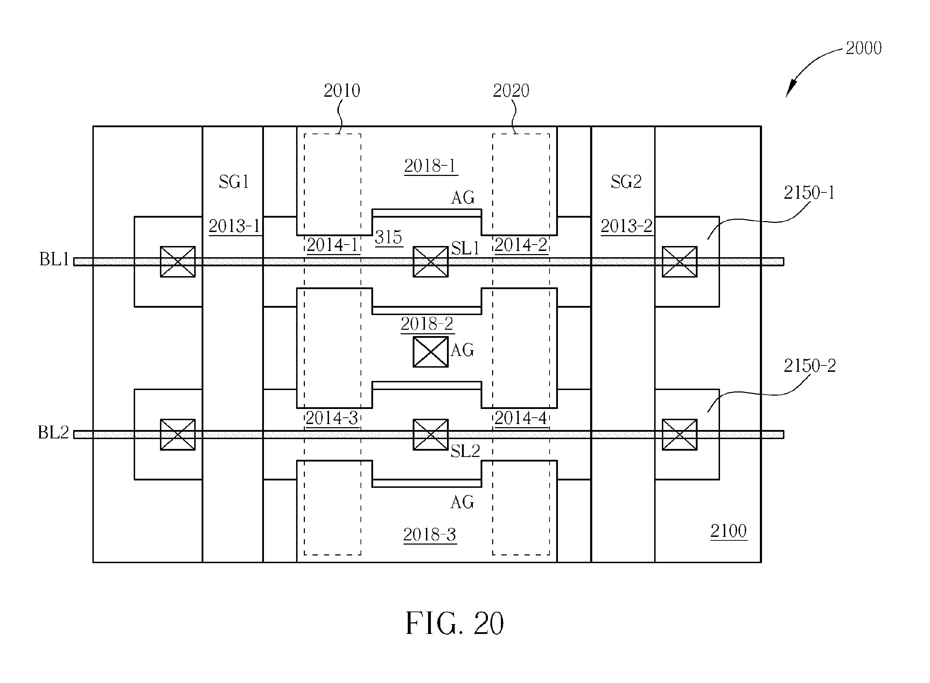

Please refer to FIG 20, which is a diagram of a non-volatile memory array 2000 based on the non-volatile memory cell structure shown in FIG 16. Four memory cells are shown in FIG 20 as an example, with the array 2000 being extendable to much greater numbers of cells. As shown in FIG 20, the non-volatile memory array 2000 comprises a plurality of select gates 2013-1, 2013-2, a plurality of auxiliary gates 2018-1, 2018-2, 2018-3, and a plurality of charge-storing layers 2014-1, 2014-2, 2014-3, 2014-4, which form memory cells over active regions 2150-1, 2150-2 of a substrate. Each auxiliary gate 2018-1, 2018-2, 2018-3 corresponds to four memory cells. For example, the auxiliary gate 2018-2 is used to program each of the charge-storing layers 2014-1, 2014-2, 2014-3, 2014-4. Photoresist mask regions 2010, 2020 are used to define the charge-storing layers 2014-1, 2014-2, 2014-3, 2014-4 in an etching process.

It can be seen that the memory cells 1100, 1300, 1500, 1600 and memory array 2000 have enhanced current density through the SAN layers 314, 2014-1, 2014-2, 2014-3, 2014-4, which improves performance over the prior art. Further, the use of photoresist to shorten length of the charge-storing layers 314, 2014-1, 2014-2, 2014-3, 2014-4 increases programming efficiency, and prevents the gap 900 that forms due to polysilicon pull-back and rounding.

For completeness, further various aspects of the invention are set out in the following numbered clauses:
Clause 1: A non-volatile memory array comprising:
   a substrate of a first conductivity type;
   a plurality of active regions on the substrate; and
   a plurality of memory cells, each memory cell formed on one active region of the plurality of active regions, each memory cell comprising:
      a select gate formed fully on the one active region;
      a first gate formed partially on the active region on a first side of the select gate, wherein the select gate and the first gate are separated by a first distance, and the first gate is longer than a minimum gate length rule of the logic process;
      a second gate formed partially on the one active region on the first side of the select gate, wherein the second gate and the select gate are separated by the first distance, the first gate and the second gate are separated by a second distance, and the second gate is substantially the same length as the first gate;
      a charge storage layer formed between the first gate and the second gate;
      a first diffusion region of a second conductivity type opposite the first conductivity type formed on the surface of the active region, wherein the first diffusion region and the second gate are formed on opposite sides of the select gate;
      a second diffusion region of the second conductivity type formed on the surface of the active region, wherein the second diffusion region and the select gate are formed on opposite sides of the first gate; and
      wherein first diffusion regions of the plurality of memory cells are electrically connected to each other, and second diffusion regions of the plurality of memory cells are electrically connected to each other.
Clause 2: The non-volatile memory array of clause 1, wherein each charge storage layer of each memory unit is underlapped by an N-- implantation region.
Clause 3: The non-volatile memory array of clause 1, wherein each charge storage layer of each memory unit has length shorter than the length of the first gate and the second gate.
Clause 4: The non-volatile memory array of clause 1, wherein each charge storage layer of each memory unit formed on the surface of the active region further fills between the select gate, the first gate and the second gate.

## Claims

1. A method of forming a charge-storing layer (314, 2014-1, 2014-2, 2014-3, 2014-4) in a non-volatile memory cell (300, 1100, 1300, 1500, 1600, 2000) in a logic process, the method comprising:
forming a select gate (313-1, 2013-1, 2013-2) over an active region (315, 715, 815, 2150-1, 2150-2) of a substrate; and
**characterized by**:
forming long polysilicon gates (313-2, 313-3, 713-2, 713-3, 813-1, 813-2[N], 1118-1, 1118-2) partially overlapping the active region (315, 715, 815, 2150-1, 2150-2) of the substrate; and
filling the charge-storing layer (314, 2014-1, 2014-2, 2014-3, 2014-4) between the long polysilicon gates (313-2, 313-3, 713-2, 713-3, 813-1, 813-2[N], 1118-1, 1118-2).

2. The method of claim 1, further **characterized by** forming the long polysilicon gates (313-2, 313-3, 713-2, 713-3, 813-1, 813-2[N], 1118-1, 1118-2) a first length long, and the first length is longer than a minimum gate length rule of the logic process.

3. The method of claim 2, further **characterized by** forming an N-- implantation region (1350) under the charge-storing layer (314, 2014-1, 2014-2, 2014-3, 2014-4).

4. The method of claim 2, further **characterized by:**
covering the charge-storing layer (314, 2014-1, 2014-2, 2014-3, 2014-4) with a photoresist mask (1510, 1610, 2010, 2020); and
etching the charge-storing layer (314, 2014-1, 2014-2, 2014-3, 2014-4) to a second length shorter than the first length.

5. A non-volatile semiconductor memory device (300, 700, 1100, 1300, 1500, 1600, 2000) formed in a logic process, the non-volatile semiconductor memory device (300, 1100, 1300, 1500, 1600, 2000) comprising:
a substrate of a first conductivity type comprising an active region (315, 715, 815, 2150-1, 2150-2); and
**characterized by:**
a first gate formed (313-2, 713-2, 813-1, 1118-1) partially in the active region (315, 715, 815, 2150-1, 2150-2) on a first region of a surface of the substrate, wherein the first gate (313-2, 713-2, 813-1, 1118-1) is longer than a minimum gate length rule of the logic process;
a second gate (313-3, 713-3, 813-2[N], 1118-2) formed partially in the active region (315, 715, 815, 2150-1, 2150-2) on a second region of the surface of the substrate, wherein the first region and the second region are separated by a first distance, and the second gate (313-3, 713-3, 813-2[N], 1118-2) is substantially the same length as the first gate (313-2, 713-2, 813-1, 1118-1);
a charge storage layer (314, 2014-1, 2014-2, 2014-3, 2014-4) formed on the substrate, wherein the charge storage layer (314, 2014-1, 2014-2, 2014-3, 2014-4) is filled between the first gate (313-2, 713-2, 813-1, 1118-1) and the second gate (313-3, 713-3, 813-2[N], 1118-2).

6. The non-volatile memory device (300, 700, 1100, 1300, 1500, 1600, 2000) of claim 5, further **characterized by:**
a first diffusion region (311-1, 711-1) of a second conductivity type opposite the first conductivity type formed on a first side of the charge storage layer (314, 2014-1, 2014-2, 2014-3, 2014-4) in the active region (315, 715, 815, 2150-1, 2150-2); and
a second diffusion region (311-2, 711-2) of the second conductivity type formed on a second side of the charge storage layer (314, 2014-1, 2014-2, 2014-3, 2014-4) opposite the charge storage layer (314, 2014-1, 2014-2, 2014-3, 2014-4) from the first side in the active region (315, 715, 815, 2150-1, 2150-2).

7. The non-volatile memory device (300, 700, 1100, 1300, 1500, 1600, 2000) of claim 5, wherein the charge storage layer (314, 2014-1, 2014-2, 2014-3, 2014-4) is underlapped by an N-- implantation region (1350).

8. The non-volatile memory device (300, 700, 1100, 1300, 1500, 1600, 2000) of claim 5, further **characterized in that** the charge storage layer (314, 2014-1, 2014-2, 2014-3, 2014-4) has length shorter than the length of the first gate (313-2, 713-2, 813-1, 1118-1) and the second gate (313-3, 713-3, 813-2[N], 1118-2).

9. The non-volatile memory device (300, 700, 1100, 1300, 1500, 1600, 2000) of claim 5, further **characterized in that** the charge storage layer (314, 2014-1, 2014-2, 2014-3, 2014-4) formed on the surface of the active region (315, 715, 815, 2150-1, 2150-2) further fills between a select gate (313-1, 2013-1, 2013-2), the first gate (313-2, 713-2, 813-1, 1118-1) and the second gate (313-3, 713-3, 813-2[N], 1118-2).
